# EUROPEAN PATENT APPLICATION

(11) **EP 4 814 517 A1**
(43) Date of publication of application: **30.09.2026**
(21) Application number: 24893877.1
(22) Date of filing: 04.10.2024
(51) Int. Cl.: G01R 33/02, G01R 15/18

(54) **SENSOR DEVICE**

(30) Priority: 24.11.2023 WO PCT/JP2023/042221
(71) Applicant: Sumida Corporation, Tokyo 104-0042 (JP)
(72) Inventor: MIYAZAKI, Hiroyuki, Natori City, Miyagi 9811226 (JP); HATAKEYAMA, Takeshi, Natori City, Miyagi 9811226 (JP)
(74) Representative: Grünecker Patent- und Rechtsanwälte PartG mbB
(86) International application number: PCT/JP2024/035640
(87) International publication number: WO 2025/109883

(57) **Abstract**

A sensor device (1) includes: a magnetic core unit (2) capable of forming a closed magnetic path including two outer leg portions; two coil portions (L1 and L2) that are constituted by windings being wound around the two outer leg portions, respectively, and generate respective signal magnetic fluxes according to AC signals applied; a magnetic flux generation unit that generates a bias magnetic flux to circulate in the closed magnetic path; an AC signal circuit (3) that applies an AC signal to the two coil portions so as to generate the signal magnetic flux in the same direction as the bias magnetic flux at the outer leg portions; and signal output terminals (V1 and V2) that output a detection signal capable of detecting voltage balance between the two coil portions (L1 and L2), the voltage balance changing depending on an external magnetic field acting on the magnetic core unit (2).

## Description

### TECHNICAL FIELD

The present invention relates to a sensor device based on magnetic detection.

### BACKGROUND ART

As a magnetic sensor, there has been known a Hall element, which uses the Hall effect to perform magnetic detection.

PATENT DOCUMENTS 1 and 2 below disclose current sensors in which a Hall element is disposed in a gap in a magnetic core. PATENT DOCUMENT 1 below presents, as a problem, generation of detection errors caused by changes in properties of the magnetic core and the Hall element along with a temperature change, and a temperature compensation circuit is added to an amplification circuit for output signals of the Hall element in order to solve the problem. In addition, in PATENT DOCUMENT 2 below, in order to reduce errors caused by the accuracy of the Hall element placement when assembling the sensor, the Hall element is used to detect the direction of a detection target current and not directly used to measure the magnitude of the detection target current.

### CITATION LIST

### PATENT DOCUMENTS

PATENT DOCUMENT 1: Japanese Patent Laid-open No. 63-61961
PATENT DOCUMENT 2: Japanese Patent Laid-open No. 2012-37508

### SUMMARY OF THE INVENTION

### PROBLEM TO BE SOLVED BY THE INVENTION

As described above, the Hall element is affected by a temperature change, placement during sensor assembly, and the like, to result in generation of detection errors. Therefore, in a case where the Hall element is used as a magnetic sensor, it is necessary to correct the properties of the Hall element alone in order to ensure detection accuracy, but such property correction is highly difficult, which is a problem.

The present invention has been made in view of such a problem, and provides a sensor device that is difficult to be affected by environmental changes and can maintain magnetic detection accuracy.

### MEANS FOR SOLVING THE PROBLEM

One aspect of the present invention is a sensor device including: a first magnetic core unit capable of forming a first closed magnetic path including two outer leg portions; two coil portions that are constituted by windings being wound around the two outer leg portions, respectively, and generate respective signal magnetic fluxes according to AC signals applied; a magnetic flux generation unit that generates a bias magnetic flux to circulate in the first closed magnetic path; an AC signal circuit that applies an AC signal to the two coil portions so as to generate the signal magnetic flux in the same direction as the bias magnetic flux at the outer leg portions; and a signal output terminal that outputs a detection signal capable of detecting voltage balance between the two coil portions, the voltage balance changing depending on an external magnetic field acting on the first magnetic core unit.

### EFFECT OF THE INVENTION

According to the above aspect, it is possible to provide a sensor device that is difficult to be affected by environmental changes and can maintain magnetic detection accuracy.

### BRIEF DESCRIPTION OF THE DRAWINGS

[FIG. 1] FIG. 1 is a schematic diagram indicative of the configuration of a sensor device according to a first embodiment.
[FIG. 2] FIG. 2 is a schematic diagram indicative of flows of magnetic flux in a magnetic core unit.
[FIG. 3] FIG. 3 is a schematic diagram indicative of the configuration of a sensor device according to a second embodiment.
[FIG. 4] FIG. 4 is a schematic diagram indicative of the configuration of a sensor device according to a third embodiment.
[FIG. 5] FIG. 5 is a graph indicative of core properties (permeability and magnetizing force properties) of a magnetic core.
[FIG. 6] FIG. 6 is a schematic diagram indicative of the configuration of a sensor device according to a fourth embodiment.
[FIG. 7] FIG. 7 is a circuit diagram indicative of a first example of an AC signal circuit and a signal output circuit.
[FIG. 8] FIG. 8 is a diagram indicative of an example of output signals in a case where the AC signal circuit and the signal output circuit indicated in FIG. 7 are applied.
[FIG. 9] FIG. 9 is a circuit diagram indicative of a second example of an AC signal circuit and a signal output circuit.
[FIG. 10] FIG. 10 is a diagram indicative of an example of output signals in a case where the AC signal circuit and the signal output circuit indicated in FIG. 9 are applied.
[FIG. 11] FIG. 11 is a schematic diagram indicative of the appearance of a current sensor device according to a fifth embodiment.
[FIG. 12] FIG. 12 is a partial schematic diagram indicative of the placement of the magnetic core unit of the sensor device in the current sensor device according to the fifth embodiment.
[FIGS. 13] FIGS. 13 are graphs each indicative of an example of voltage signals (detection signals) output from signal output terminals in the current sensor device according to the fifth embodiment.
[FIGS. 14] FIGS. 14 are schematic diagrams each indicative of an example of the placement of a current sensor device according to a sixth embodiment with respect to a current line.
[FIG. 15] FIG. 15 is a schematic diagram indicative of the appearance of a sensor device according to a seventh embodiment.
[FIG. 16] FIG. 16 is a schematic diagram indicative of flows of signal magnetic flux and bias magnetic flux in the sensor device according to the seventh embodiment.
[FIG. 17] FIG. 17 is a schematic diagram indicative of the appearance of the sensor device according to a modification of the seventh embodiment.
[FIGS. 18] FIGS. 18 are schematic diagrams each indicative of an example of the placement of a current sensor device according to an eighth embodiment with respect to the current line.
[FIG. 19] FIG. 19 is a graph indicative of results of the evaluation test of a current sensor device in the Example.

### DESCRIPTION OF EMBODIMENTS

Next, embodiments of the present invention will be described. Note that each of the embodiments provided below is an example, and the present invention is not limited to the configurations of the respective embodiments below.

### [First Embodiment]

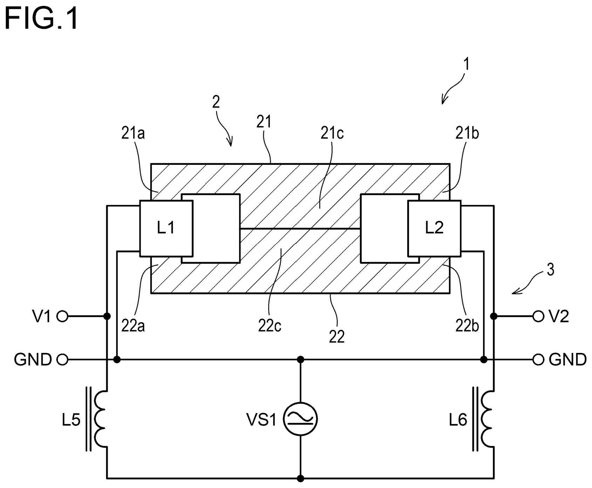

FIG. 1 is a schematic diagram indicative of the configuration of a sensor device 1 according to a first embodiment.

The sensor device 1 according to the first embodiment includes a magnetic core unit 2, coil portions L1 and L2, an AC signal circuit 3, signal output terminals V1 and V2, and the like.

In the example of FIG. 1, the magnetic core unit 2 forms a closed magnetic path in which E-type cores 21 and 22 each having a middle leg portion and two outer leg portions are butted against each other, to have a core shape called EE-type core. The E-type core 21 has outer leg portions 21a and 21b and a middle leg portion 21c, and the E-type core 22 has outer leg portions 22a and 22b and a middle leg portion 22c. The middle leg portions 21c and 22c may have a cylindrical shape or a prismatic shape. The magnetic core unit 2 corresponds to a first magnetic core unit.

Hereafter, the continuous outer legs 21a and 22a and the continuous outer legs 21b and 22b may be each sometimes represented as core outer leg portion, and the continuous middle leg portions 21c and 22c may be sometimes represented as core middle leg portion.

The shape of the magnetic core unit 2 is not limited to the example indicated in FIG. 1, and only needs to be a shape that forms a closed magnetic path including two outer leg portions. For example, the magnetic core unit 2 may be an EI-type core. Furthermore, the magnetic core unit 2 may have a core shape without a middle leg portion, such as a UU-type core.

Furthermore, the magnetic core unit 2 only needs to be a general magnetic core such as a ferrite core or a dust core, and a material and a forming method thereof are not limited.

The coil portions L1 and L2 are constituted by windings being wound around the respective outer leg portions (respective core outer leg portions) of the magnetic core unit 2. In the example of FIG. 1, the coil portion L1 is constituted by windings being wound around the outer leg portions 21a and 22a of the E-type cores 21 and 22, respectively, and the coil portion L2 is constituted by windings being wound around the outer leg portions 21b and 22b of the E-type cores 21 and 22.

The AC signal circuit 3 is a circuit that applies an AC signal to the coil portions L1 and L2. The AC signal circuit 3 applies the AC signal to the coil portions L1 and L2 so that the magnetic flux generated by the coil portion L1 and the magnetic flux generated by the coil portion L2 have polarity to circulate in the same direction in the closed magnetic path of the magnetic core unit 2. In the example of FIG. 1, on the AC signal applied to the coil portions L1 and L2, a DC bias current is superimposed.

In the example of FIG. 1, the AC signal circuit 3 includes coils L5 and L6 and is connected to an AC signal source VS1.

The AC signal circuit 3 is configured such that each of the coil portions L1 and L2 is connected in parallel to the AC signal source VS1.

The coil L5 is connected in series to the coil portion L1, and the coil L6 is connected in series to the coil portion L2. The coils L5 and L6 remove noise components of the AC signals applied to the coil portions L1 and L2, respectively.

In this embodiment, as described later, the coils L5 and L6 are connected in series as reactance elements to the coil portions L1 and L2, respectively, in order to output the impedance of the coil portions L1 and L2 as voltage signals.

The AC signal source VS1 supplies an AC signal on which a DC bias current is superimposed.

The signal output terminals V1 and V2 are terminals that are connected to the AC signal circuit 3 and output a detection signal capable of detecting the voltage balance between the coil portion L1 and the coil portion L2. In the example of FIG. 1, the signal output terminal V1 outputs a voltage signal applied to the coil portion L1, and the signal output terminal V2 outputs a voltage signal applied to the coil portion L2. According to the voltage signals output from the signal output terminals V1 and V2, the voltage difference between the coil portion L1 and the coil portion L2 can be detected, so both output signals can be called detection signals capable of detecting the voltage balance between the coil portion L1 and the coil portion L2.

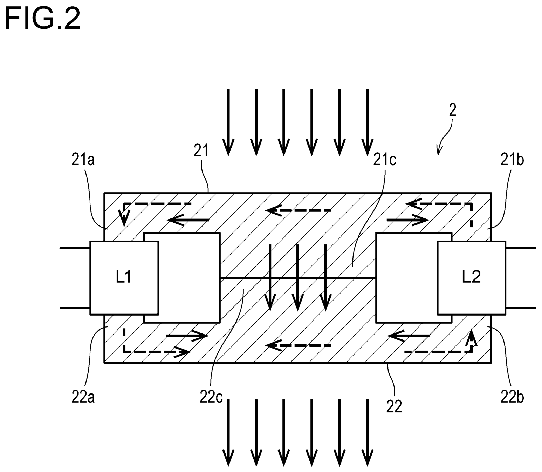

FIG. 2 is a schematic diagram indicative of flows of magnetic flux in the magnetic core unit 2.

In the magnetic core unit 2, the magnetic fluxes (hereinafter, sometimes referred to as signal magnetic flux) generated by the AC signals applied to the coil portions L1 and L2 flow in a circulating direction from one core outer leg portion through the other core outer leg portion in the magnetic core unit 2. These signal magnetic fluxes are indicated by dashed arrows in FIG. 2.

On the other hand, as indicated by solid arrows in FIG. 2, when an external magnetic field acts on the magnetic core unit 2 in the extending direction of the core middle leg portion, the magnetic flux based on the external magnetic field flows into the magnetic core unit 2.

At this time, the majority of the magnetic flux based on the external magnetic field flows through the core middle leg portion, and a leaked portion therefrom flows through the core outer leg portions. As a result, the magnetic flux that is the signal magnetic flux to which the leaked portion of the magnetic flux based on the external magnetic field is added flows through one core outer leg portion (left side on the page of FIG. 2), and the magnetic flux that is the signal magnetic flux from which the leaked portion of the magnetic flux based on the external magnetic field is subtracted flows through the other core outer leg portion (right side of the page of FIG. 2).

Therefore, in a state where the external magnetic field does not act on the magnetic core unit 2, voltage signals of the same phase and the same level are output from the signal output terminals V1 and V2. On the other hand, as described above, in a state where the external magnetic field as indicated in FIG. 2 acts on the magnetic core unit 2, a difference occurs between the amount of magnetic flux passing through the coil portion L1 and the amount of magnetic flux passing through the coil portion L2, and also a difference occurs between the inductances of the coil portions L1 and L2. As a result, a difference also occurs in the levels of the voltage signals output from the signal output terminals V1 and V2. Therefore, the intensity of the external magnetic field can be indicated by the level difference between the output voltage signals.

In a case where an external magnetic field in the reverse direction to the direction indicated in FIG. 2 acts on the magnetic core unit 2, the direction of the magnetic flux based on the external magnetic field flowing through the core outer leg portions is also reversed, and therefore the largeness and smallness of the levels of the voltage signals output from the signal output terminals V1 and V2 are reversed.

Therefore, according to the present embodiment, using the voltage signals (detection signals) output from the signal output terminals V1 and V2 makes it possible to detect the intensity and direction of the external magnetic field.

In this embodiment, since detection of the intensity and direction of the external magnetic field is made possible by outputting detection signals capable of detecting the voltage balance between the coil portions L1 and L2, which changes according to the external magnetic field acting on the magnetic core unit 2, highly accurate magnetic detection is possible without being affected by hysteresis and a temperature property of the magnetic core unit 2.

Furthermore, by using a magnetic core with high permeability as the magnetic core unit 2, the detection sensitivity can be increased.

In addition, by adjusting the magnitude of the DC bias current superimposed on the AC signals to be applied to the coil portions L1 and L2, it is also possible to adjust the magnitude of the level difference between the voltage signals (detection signals) output from the signal output terminals V1 and V2.

Furthermore, according to this embodiment, if the magnetic core unit 2 has a core middle leg portion, an external magnetic field having high intensity can be targeted for detection even if the amount of windings of the coil portions L1 and L2 is small. This is because the placement of the magnetic core unit 2 with respect to the external magnetic field causes the majority of the magnetic flux based on the external magnetic field to flow through the core middle leg portion, so that the leaked portion of the magnetic flux can be used to detect the voltage balance between the coil portion L1 and the coil portion L2.

However, in a case where the intensity of the external magnetic field is not so high or the like, the magnetic core unit 2 may have a core shape not provided with a core middle portion.

### [Second Embodiment]

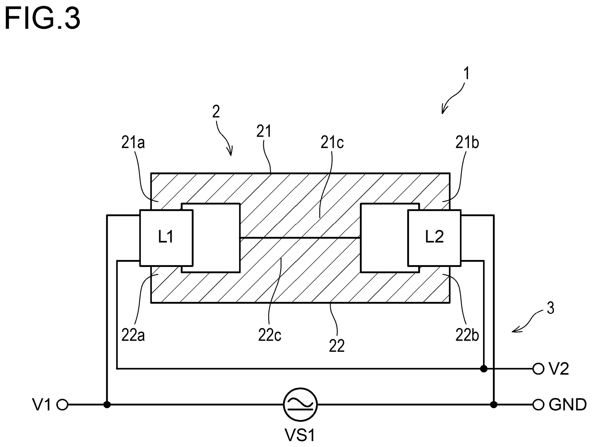

FIG. 3 is a schematic diagram indicative of the configuration of the sensor device 1 according to a second embodiment.

Hereinafter, the sensor device 1 according to the second embodiment will be described with reference to FIG. 3. In the following description, description will be made mainly focusing on the configuration different from that in the first embodiment, and the description will not be repeated for the configuration same as that in the first embodiment.

In the second embodiment, the AC signal circuit 3 does not include the coils L5 and L6, and is configured so that the coil portions L1 and L2 are connected in series to the AC signal source VS1. In the second embodiment, since the coil portions L1 and L2 are thus connected in series to mutually act as reactance elements, the coils L5 and L6 are not provided.

The AC signal source VS1 supplies an AC signal on which a DC bias current is superimposed, similarly to the first embodiment.

Furthermore, in the second embodiment, the signal output terminal V1 is connected between the AC signal source and the coil portion L1, and the signal output terminal V2 is connected between the coil portion L1 and the coil portion L2. That is, the signal output terminal V2 outputs the intermediate signal level between the coil portion L1 and the coil portion L2 as a detection signal.

Therefore, if the coil portion L1 and the coil portion L2 have the same inductance, the voltage signal level output from the signal output terminal V2 is theoretically half the level of the voltage signal output from the signal output terminal V1.

However, in a case where a difference occurs between the amount of magnetic flux passing through the coil portion L1 and the amount of magnetic flux passing through the coil portion L2 due to the action of the external magnetic field to cause a difference to occur in the inductances of the coil portions L1 and L2, the level of the voltage signal output from the signal output terminal V2 is not half the level of the voltage output from the signal output terminal V1. Therefore, both output signals of the signal output terminals V1 and V2 can be called detection signals capable of detecting the voltage balance between the coil portion L1 and the coil portion L2.

In this manner, also in the sensor device 1 according to the second embodiment, the same operational effects can be obtained as in the first embodiment.

### [Third Embodiment]

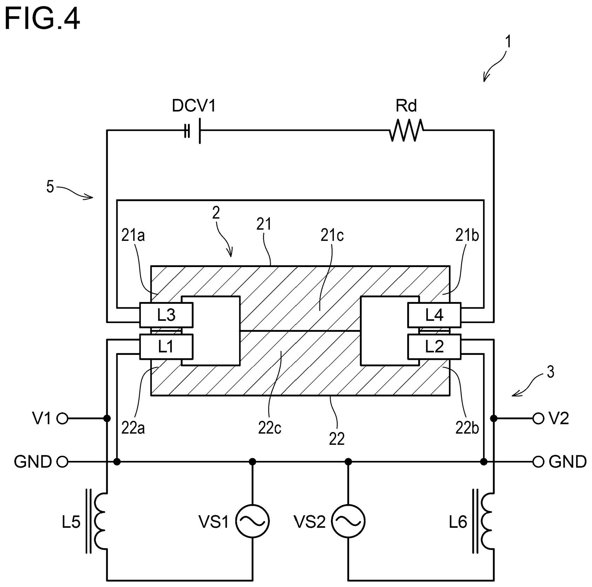

FIG. 4 is a schematic diagram indicative of the configuration of the sensor device 1 according to a third embodiment.

Hereinafter, the sensor device 1 according to the third embodiment will be described with reference to FIG. 4. In the following description, description will be made mainly focusing on the configuration different from that in the first embodiment, and the description will not be repeated for the configuration same as that in the first embodiment.

The sensor device 1 according to the third embodiment further includes bias coil portions L3 and L4 and a DC signal circuit 5 in addition to the configurations of the first embodiment.

The bias coil portions L3 and L4 are constituted by windings being wound around the respective core outer leg portions of the magnetic core unit 2, separately from the coil portions L1 and L2. In the example of FIG. 4, the coil portion L1 is constituted by windings being wound around the outer leg portion 22a of the E-type core 22, the coil portion L2 is constituted by windings being wound around the outer leg portion 22b of the E-type core 22, the bias coil portion L3 is constituted by a winding being wound around the outer leg portion 21a of the E-type core 21, and the bias coil portion L4 is constituted by a winding being wound around the outer leg portion 21b of the E-type core 21.

The DC signal circuit 5 is a circuit that applies a DC signal to the bias coil portions L3 and L4. The DC signal circuit 5 applies the DC signals to the bias coil portions L3 and L4, respectively, so that the magnetic flux generated by the bias coil portion L3 and the magnetic flux generated by the bias coil portion L4 have polarity to circulate in the same direction in the closed magnetic path of the magnetic core unit 2. The magnetic flux generated in the magnetic core unit 2 by the DC signals flowing through the bias coil portions L3 and L4 may be sometimes represented as bias magnetic flux.

In the example of FIG. 4, the DC signal circuit 5 includes a resistive element Rd and is connected to a DC power supply DCV1.

The DC signal circuit 5 is configured so that each of the resistive element Rd and the bias coil portions L3 and L4 is connected in series to the DC power supply DCV1.

Furthermore, in the third embodiment, the AC signal circuit 3 is connected to AC signal sources VS1 and VS2 as indicated in FIG. 4, and is configured so that the AC signal source VS1 applies an AC signal to the coil portion L1 via the coil L5 and the AC signal source VS2 applies an AC signal to the coil portion L2 via the coil L6.

Both the AC signal sources VS1 and VS2 only need to supply AC signals of the same phase and the same level, and the same operational effects can be obtained as obtained in the configurations in the first embodiment.

In the third embodiment, since the configurations (bias coil portions L3 and L4, DC signal circuit 5) for flowing the bias magnetic flux are provided as described above, the AC signals supplied from the AC signal sources VS1 and VS2 need not to be superimposed with the DC bias current.

In the third embodiment, the bias coil portions L3 and L4 and the DC signal circuit 5 are thus newly provided to pass the bias magnetic flux through the magnetic core unit 2, so that the DC bias current is not necessarily superimposed on the AC signals applied to the coil portions L1 and L2.

Also in the third embodiment, by adjusting the resistance value of the resistive element Rd and the output of the DC power supply to make the amount of bias magnetic flux variable, it is possible to adjust the magnitude of the level difference between the voltage signals (detection signals) output from the signal output terminals V1 and V2.

### [Fourth Embodiment]

In the first and second embodiments described above, the AC signal on which the DC bias current is superimposed is applied to the coil portions L1 and L2, while in the third embodiment, the DC signal is applied to the bias coil portions L3 and L4 to generate bias magnetic flux in the magnetic core unit 2. Therefore, in the first and second embodiments, it is possible to represent that the AC signal circuit 3 includes a magnetic flux generation unit that generates bias magnetic flux, while in the third embodiment, it is possible to represent the bias coil portions L3 and L4 and the DC signal circuit 5 as the magnetic flux generation unit.

In each of the above embodiments, such a configuration is adopted that the signal magnetic flux and the bias magnetic flux are generated with polarity to circulate in the same direction in the closed magnetic path in the magnetic core unit 2. That is, such a configuration is adopted that the signal magnetic flux and the bias magnetic flux have the same polarity in the same direction at least in the respective core outer leg portions.

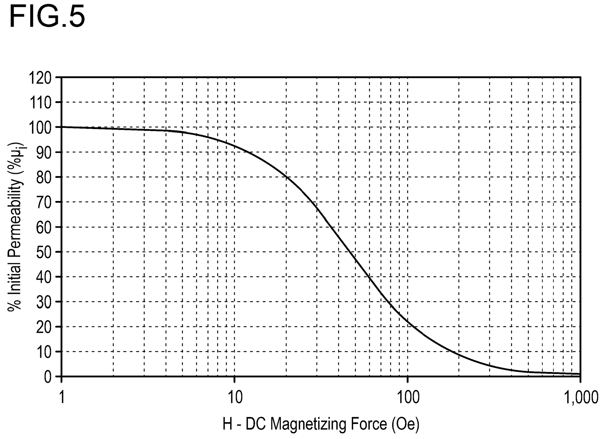

FIG. 5 is a graph indicative of core properties (permeability and magnetizing force properties) of the magnetic core. The vertical axis shows the permeability and the horizontal axis shows the magnetizing force.

As indicated in FIG. 5, the magnetic core generally has such properties that the permeability decreases as the magnetizing force generated in the core increases. The range of permeability from about 30% to about 70% is the region where permeability decays linearly relative to the increase in magnetizing force.

On the other hand, the inductance of the coil having such a magnetic core as a core material is proportional to the permeability of the magnetic core.

Since the sensor device 1 of each of the above embodiments can detect the intensity and direction of the external magnetic field through the difference in inductance between the coil portions L1 and L2 caused by the action of the external magnetic field, it is desirable to perform the detection operation within a region where the permeability in the core properties decays linearly in order to improve the detection accuracy.

To "linearly decay" here is not limited to the meaning that the permeability decays with perfect linearity (proportional relationship) with the magnetizing force, but the meaning also including that the permeability decays with approximate linearity.

Hereafter, the region where the permeability decays linearly relative to the increase in magnetizing force in the core properties may be sometimes abbreviated as permeability decay region.

Therefore, in each of the above embodiments, in order to set the base of the detection operation to a specific range within the permeability decay region in the core properties, bias magnetic flux having a predetermined magnetizing force within the specific range is generated. This specific range of permeability is preferably equal to or more than 40% and equal to or less than 60%, which is about 10% narrowed from the range of the permeability decay region (range in which permeability is about 30% to about 70%).

That is, the magnetic flux generation unit preferably generates bias magnetic flux having such a magnetizing force that falls in a permeability range of equal to or more than 40% and equal to or less than 60%, the permeability range corresponding to a specific range within the permeability decay region in the core properties of the magnetic core unit provided with the two coil portions L1 and L2. For example, the magnetic flux generation unit is configured so that bias magnetic flux having a magnetizing force in which permeability is 50% is generated.

However, in order to generate such a magnetizing force as a bias, it is necessary to make the DC bias current and the DC current applied to the bias coil portions L3 and L4 be of a certain magnitude. For example, in the example of FIG. 5, a magnetizing force of 45 oersted (Oe) is required in order to make the permeability 50%. In order to generate bias magnetic flux of that magnetizing force in the third embodiment, the number of turns of the bias coil portions L3 and L4 is required to be about 1,000 and a current of about 150 mA is required to be applied to each coil. That is, in each of the above embodiments, power or coils for generating the bias magnetic flux are required.

Therefore, in the fourth embodiment, magnets are used to generate the bias magnetic flux.

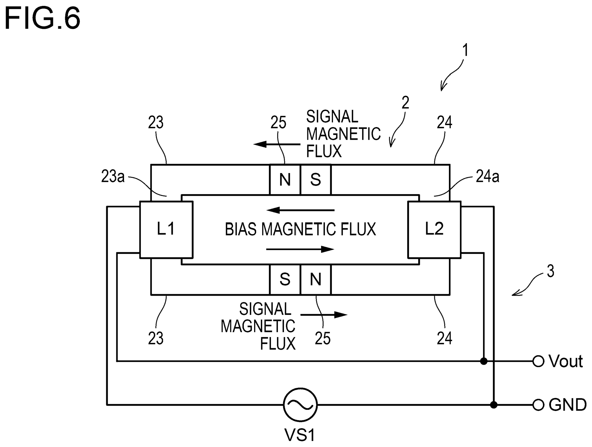

FIG. 6 is a schematic diagram indicative of the configuration of the sensor device 1 according to the fourth embodiment.

Hereinafter, the sensor device 1 according to the fourth embodiment will be described with reference to FIG. 6. In the following description, description will be made mainly focusing on the configuration different from that in the first embodiment, and the description will not be repeated for the configuration same as that in the first embodiment.

The sensor device 1 according to the fourth embodiment includes the magnetic core unit 2, the coil portions L1 and L2, bias magnet portions 25, the AC signal circuit 3, a signal output terminal Vout, a ground terminal GND, and the like.

The magnetic core unit 2 forms a closed magnetic path in which a U-type core 23 and a U-type core 24 are butted against each other via the two bias magnet portions 25, to have a core shape that can be called UU-type core. In the magnetic core unit 2, the bottom of the U-shape in the U-type core 23 forms an outer leg portion 23a, and the bottom of the U-shape in the U-type core 24 forms an outer leg portion 24a.

However, in the fourth embodiment, the shape of the magnetic core unit 2 is not limited to the example of FIG. 6, and only needs to be a shape including one or more bias magnet portions 25 in the closed magnetic path, and may be a core shape called ring core or O-type core.

The material and forming method of the magnetic core unit 2 are also not limited.

The magnetic core unit 2 in the fourth embodiment also corresponds to the first magnetic core unit.

The bias magnet portions 25 are magnets that generate bias magnetic flux in the closed magnetic path of the magnetic core unit 2. That is, the bias magnet portions 25 are locally provided in the magnetic core unit 2 so that bias magnetic fluxes are generated with polarity to circulate in the same direction in the closed magnetic path of the magnetic core unit 2. In the example of FIG. 5, the two bias magnet portions 25 are provided at mutually opposing positions of two coupling portions connecting the two outer leg portions so that the bias magnetic fluxes are generated with polarity to circulate counterclockwise on the page in the closed magnetic path formed by the magnetic core unit 2.

As a result, the signal magnetic flux generated from the coil portions L1 and L2 and the bias magnetic flux generated by the bias magnet portions 25 have the polarity in the same direction in each of the outer leg portions 23a and 24a.

However, the location and number of bias magnet portions 25 are not limited to the example of FIG. 6. The bias magnet portions 25 may be provided in the outer leg portions 23a and 24a of the magnetic core unit 2, or may be attached to the surface of the magnetic core unit 2. The bias magnet portions 25 may be provided at a plurality of diagonal points on the surface or inside of the magnetic core unit 2 in the closed magnetic path.

As described above, the magnet properties of the bias magnet portions 25 are not particularly limited, provided that it is possible to generate bias magnetic flux having a magnetizing force that falls in a permeability range of equal to or more than 40% and equal to or less than 60%, the permeability range corresponding to the specific range within the permeability decay region in the core properties of the magnetic core unit 2.

Other configurations in the fourth embodiment, that is, the AC signal circuit 3, the output terminals, and the like may be the same as those in each of the embodiments described above. In the example of FIG. 6, the midpoint between the coil portions L1 and L2 connected in series is connected to the signal output terminal Vout.

In the fourth embodiment, since the bias magnet portions 25 thus generate the bias magnetic flux, the bias coil portions L3 and L4 are not required, and power for generating the bias magnetic flux is also not required.

Therefore, according to the fourth embodiment, the manufacturing cost and power consumption of the sensor device 1 can be reduced compared with each of the embodiments described above.

### [Detailed configuration of circuit]

In each of the embodiments described above, the AC signal circuit 3 is shown as a simplified configuration in which, on the signal output side of the coil portions L1 and L2, only the signal output terminals V1 and V2 and Vout are shown.

Therefore, hereinafter, the specific configuration of the AC signal circuit 3 and the signal output circuit will be described with examples. The AC signal circuit 3 and the signal output circuit shown below are applicable to any of the embodiments described above. However, the circuit configuration of each of the embodiments described above is not limited to the following examples.

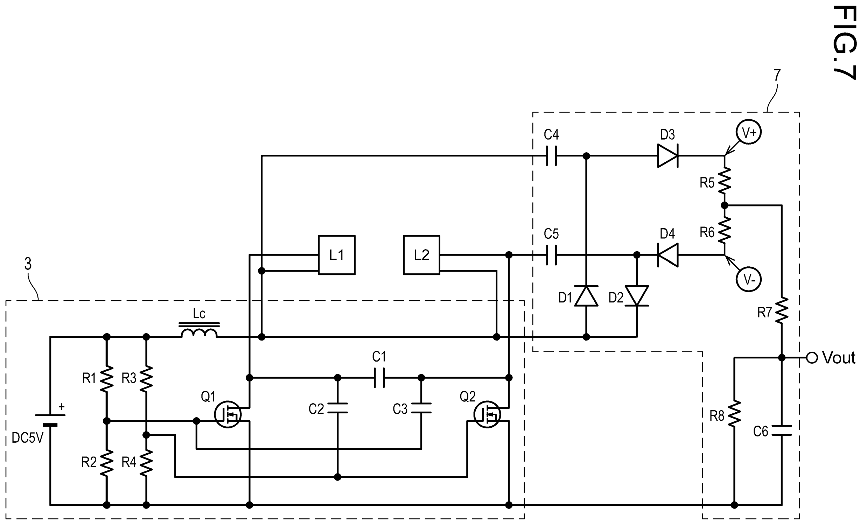

FIG. 7 is a circuit diagram indicative of a first example of the AC signal circuit 3 and a signal output circuit 7.

The AC signal circuit 3 has a resonant capacitor C1, gate timing capacitors C2 and C3, transistors Q1 and Q2, gate bias resistors R1 to R4, a choke coil Lc, and a DC power supply, and these components form a collector-resonant self-oscillation circuit.

The DC power supply is a power source that provides DC power and is a battery device or a storage battery.

The coil portions L1 and L2 are connected in series, and the midpoint therebetween is connected to the positive side of the DC power supply via the choke coil Lc.

The other end of the coil portion L1 is connected to the negative side of the DC power supply via the transistor Q1, and the other end of the coil portion L2 is connected to the negative side of the DC power supply via the transistor Q2.

The resonant capacitor C1 is connected in parallel to the coil portions L1 and L2, and forms a resonant circuit together with the coil portions L1 and L2.

The transistors Q1 and Q2 are, for example, field effect transistors (FETs) or bipolar transistors, and can be represented as a switching element pair. The drain of the transistor Q1 is connected to the coil portion L1, and the drain of the transistor Q2 is connected to the coil portion L2. Each source of the transistors Q1 and Q2 is connected to the negative side of the DC power supply. The gates of the transistors Q1 and Q2 are connected to the bias circuit.

The bias circuit is constituted by the gate bias resistors R1, R2, R3 and R4, which are connected in parallel to the DC power supply and apply bias voltage to respective gates of the transistors Q1 and Q2. Specifically, a pair of resistors R1 and R2 connected in series and a pair of resistors R3 and R4 connected in series are connected in parallel, the midpoint between the resistor R1 and the resistor R2 is connected to the gate of the transistor Q1, and the midpoint between the resistor R3 and the resistor R4 is connected to the gate of the transistor Q2.

The gate of the transistor Q1 is connected to one end of the resonant capacitor C1 via the gate timing capacitor C2, and the gate of the transistor Q2 is connected to the other end of the resonant capacitor C1 via the gate timing capacitor C3. As a result, the switching operation of the transistors Q1 and Q2 is performed according to the charging and discharging of the resonant capacitor C1 and the gate timing capacitors C2 and C3.

With the configuration as described above, the AC signal circuit 3 can apply oscillation signals (sinusoidal signals) to the coil portions L1 and L2 based on the DC power supplied from the DC power source. The AC signal circuit 3 uses a self-oscillation circuit to generate the oscillation signal, to thereby realize simplification of the circuit configuration.

On the other hand, the signal output circuit 7 is provided on the signal output terminal Vout side of the coil portions L1 and L2. The signal output circuit 7 includes coupling capacitors C4 and C5, rectifier diodes D1, D2, D3, and D4, balance resistors R5 and R6, output resistors R7 and R8, and an output capacitor C6.

The coupling capacitors C4 and C5 and the rectifier diodes D1 to D4 form a voltage doubler rectifier circuit, which rectifies the signals at both ends of the coil portions L1 and L2 to both of the positive side and the negative side.

The balance resistors R5 and R6 and the output resistors R7 and R8 perform voltage division of the signal rectified by the above voltage doubler rectifier circuit, and the output capacitor C6 smooths the voltage-divided signal to output the DC signal to the signal output terminal Vout.

Therefore, the output signal from the signal output terminal Vout can be called a detection signal capable of detecting the voltage balance between the coil portion L1 and the coil portion L2.

With the configuration as described above, in a case where no external magnetic field acts and no difference occurs between the inductances of the coil portions L1 and L2, the DC signal having a voltage value biased by the DC voltage supplied from the DC power supply of the AC signal circuit 3 (including the divided voltage by the balance resistors R5 and R6, and the like) is output from the signal output terminal Vout. On the other hand, in a case where a difference occurs between the inductances of the coil portions L1 and L2 due to the action of the external magnetic field, the voltage value changes up and down according to the direction of the magnetic flux of the external magnetic field based on the above biased voltage value.

The base voltage value of the output signal can be set as desired by the ratio of the resistance values of the balance resistors R5 and R6 and the output resistors R7 and R8.

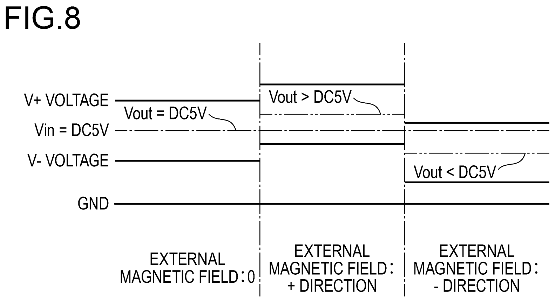

FIG. 8 is a diagram indicative of an example of output signals in a case where the AC signal circuit 3 and the signal output circuit 7 indicated in FIG. 7 are applied. This example shows output signals of a case where the balance resistors R5 and R6 in the signal output circuit 7 have the same resistance value and the output resistor R8 is open.

As indicated in FIG. 8, the output signal shows a voltage value (5 V = reference voltage value) of the DC power supply of the AC signal circuit 3 in a case where the external magnetic field is not acting, a voltage value higher than the reference voltage value in a case where the external magnetic field acts in the positive direction, and a voltage value lower than the reference voltage value in a case where the external magnetic field acts in the negative direction.

Depending on the magnitude of the magnetizing force of the external magnetic field, the difference between the voltage value of the output signal and the reference voltage value increases.

In this manner, according to the AC signal circuit 3 and the signal output circuit 7 indicated in FIG. 7, it is possible to use the output signal to detect the intensity and direction of the external magnetic field.

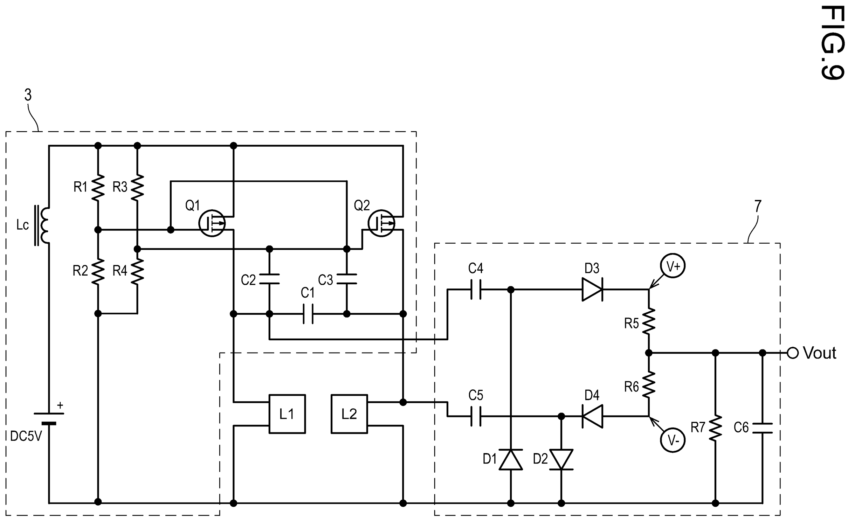

FIG. 9 is a circuit diagram indicative of a second example of the AC signal circuit 3 and the signal output circuit 7.

Hereinafter, the circuit configuration of the second example will be described mainly on details different from those in the first example, and the description will not be repeated for details same as those in the first example.

The AC signal circuit 3 in the second example has the circuit configuration same as that in the first example, but circuit connections are different from those in the first example.

In the second example, the midpoint between the coil portion L1 and the coil portion L2 is connected to the negative side (GND) of the DC power supply, the other end of the coil portion L1 is connected to the positive side of the DC power supply via the transistor Q1, and the other end of the coil portion L2 is connected to the positive side of the DC power supply via the transistor Q2.

Furthermore, the source of the transistor Q1 is connected to the coil portion L1, the source of the transistor Q2 is connected to the coil portion L2, and the respective drains of the transistors Q1 and Q2 are connected to the positive side of the DC power supply.

The signal output circuit 7 in the second example differs from the circuit configuration in the first example in not being provided with the output resistor R8. The signal output circuit 7 in the second example differs from the first example also in circuit connections.

In the first example, the midpoint between the rectifier diodes D1 and D2 is connected to the positive side of the DC power supply, whereas in the second example, the midpoint between the rectifier diodes D1 and D2 is connected to the negative side (GND) of the DC power supply. Furthermore, the output capacitor C6 and the output resistor R7 are connected in parallel with each other.

In this manner, in the second example, the midpoint between the coil portion L1 and the coil portion L2 and the midpoint between the rectifier diodes D1 and D2 are both connected to the negative side (GND) of the DC power supply. As a result, in a case where no external magnetic field acts and no difference occurs between the inductances of the coil portions L1 and L2, a DC signal corresponding to the ground (GND) potential is output from the signal output terminal Vout. On the other hand, in a case where a difference between the inductances of the coil portions L1 and L2 occurs by the action of the external magnetic field, a DC signal indicating the voltage difference between the coil portion L1 and the coil portion L2 with respect to the ground potential is output.

Therefore, according to the second example, only the change in the voltage balance of the coil portions L1 and L2 along with the action of the external magnetic field can be indicated by the output signal.

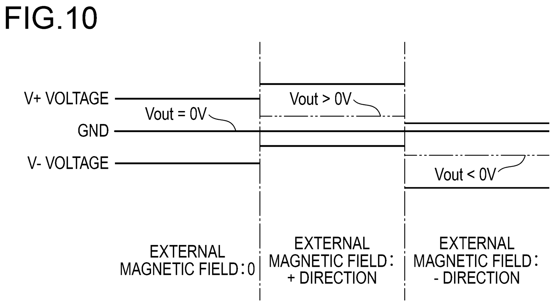

FIG. 10 is a diagram indicative of an example of output signals in a case where the AC signal circuit 3 and the signal output circuit 7 indicated in FIG. 9 are applied. This example shows output signals of a case where the balance resistors R5 and R6 in the signal output circuit 7 have the same resistance value.

As indicated in FIG. 10, the output signal shows a voltage value (0 V) corresponding to the ground voltage in a case where the external magnetic field is not acting, a positive voltage value in a case where the external magnetic field acts in the positive direction, and a negative voltage value in a case where the external magnetic field acts in the negative direction.

Depending on the magnitude of the magnetizing force of the external magnetic field, the absolute value of the voltage value of the output signal increases.

In this manner, according to the AC signal circuit 3 and the signal output circuit 7 indicated in FIG. 9, it is possible not only to use the output signal to detect the intensity and direction of the external magnetic field, but also to use the output signal to indicate only the change in the voltage balance of the coil portions L1 and L2 due to the action of the external magnetic field.

Note that, as mentioned above, the AC signal circuit 3 and the signal output circuit 7 are not limited to the circuit configuration indicated in FIGS. 7 and 9.

For example, in the AC signal circuit 3 of the first example and the second example (see FIGS. 7 and 9), the resonant capacitor C1 connected in parallel to the coil portions L1 and L2 is provided, but the resonant capacitor C1 may be eliminated. Even with a configuration in which the resonant capacitor C1 is eliminated, in a case where the transistors Q1 and Q2 are FETs, self-oscillation is possible by the output capacitance of the transistors Q1 and Q2 (Coss = drain-source capacitance (Cds) + gate-drain capacitance (Cgd)).

### [Fifth Embodiment]

In a case where the external magnetic field detectable by the sensor device 1 according to each of the embodiments described above is generated by an external current, the magnitude and direction of the external current can be detected by the detection signal output from the sensor device 1.

In the fifth embodiment, a current sensor device 10 that includes the configuration of the first, second, third, or fourth embodiment described above will be described. In the following description, description will be made mainly focusing on the configuration different from that in each of the embodiments described above, and the description will not be repeated for the configuration same as that in each of the embodiments described above.

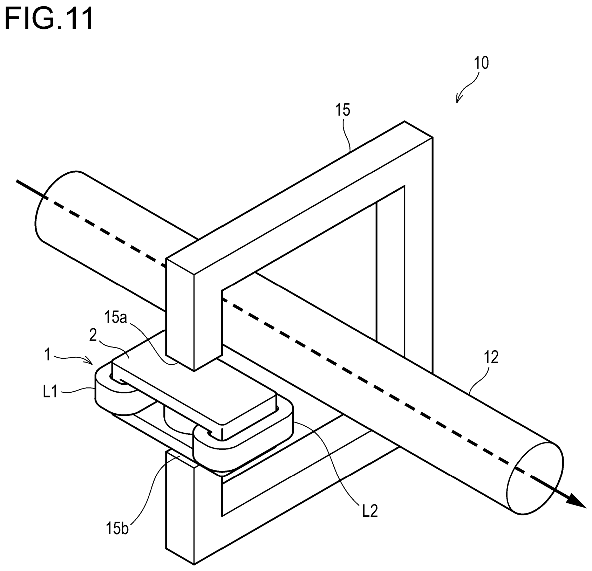

FIG. 11 is a schematic diagram indicative of the appearance of the current sensor device 10 according to the fifth embodiment.

The current sensor device 10 according to the fifth embodiment includes a magnetic core for current detection (hereinafter, abbreviated as current detection core) 15 in addition to the sensor device 1 according to the first, second, third, or fourth embodiment described above.

As indicated in FIG. 11, the current detection core 15 is a magnetic core that has an air gap and is configured so that the air gap is interposed in the magnetic path formed by a flow of a detection target current. In the example of FIG. 11, the current detection core 15 is formed into a square ring shape having one side cut in the middle to be provided with a gap. However, the shape of the current detection core 15 is not limited to the example of FIG. 11, and may be a donut shape like a toroidal core in which a gap is provided in the middle. Furthermore, the material and forming method of the current detection core unit 15 are also not limited.

In the example of FIG. 11, a current line 12 through which the detection target current flows is inserted into the current detection core 15. However, the current line 12 may be wound around the current detection core 15.

In the current sensor device 10, the magnetic core unit 2 of the sensor device 1 preferably has a core middle leg portion and two core outer leg portions as indicated in FIG. 1. That is, in the current sensor device 10, the magnetic core unit 2 preferably has a core shape called EE-type core or EI-type core.

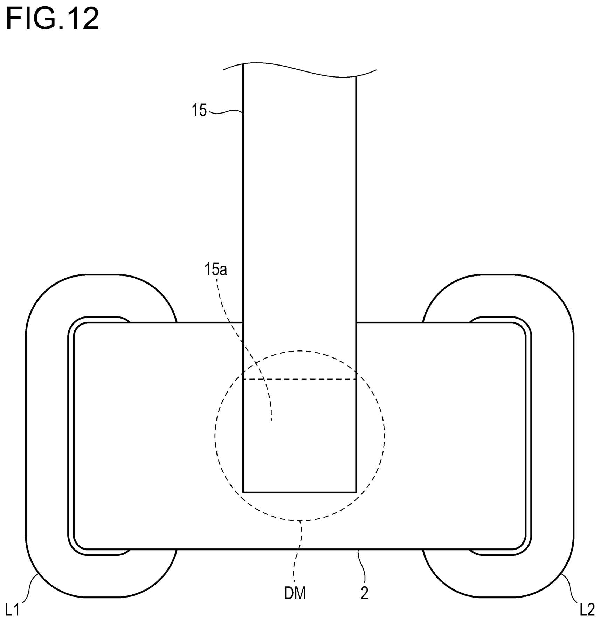

FIG. 12 is a partial schematic diagram indicative of the placement of the magnetic core unit 2 of the sensor device 1 in the current sensor device 10 according to the fifth embodiment.

As indicated in FIG. 11, the magnetic core unit 2 is placed in the air gap of the current detection core 15 in a direction in which the two core outer leg portions and the core middle leg portion extend in a direction orthogonal to core end surfaces 15a and 15b opposed to each other via the air gap in the current detection core 15.

Furthermore, as indicated in FIGS. 11 and 12, the magnetic core unit 2 is preferably placed in a direction in which the distances from the current line 12 to each of the coil portions L1 and L2 are approximately equal to each other. With this placement, it is possible to prevent the magnetic flux flowing through the two core outer leg portions of the magnetic core unit 2 from being unbalanced due to the magnetic field generated from the current line 12.

Furthermore, the magnetic core unit 2 is preferably formed so that an area of a cross section DM orthogonal to the extending direction in the core middle leg portion is the same as or larger than the respective areas of the core end surfaces 15a and 15b of the current detection core 15. In other words, the core middle leg portion of the magnetic core unit 2 preferably has such a size (volume) that is not saturated by the magnetic flux generated by the detection target current and flowing between the core end surfaces 15a and 15b of the current detection core 15 (hereinafter, sometimes referred to as external magnetic flux).

Besides, as indicated in FIG. 12, when viewed from the direction orthogonal to the core end surfaces 15a and 15b (from the page of FIG. 12), the magnetic core unit 2 is preferably positioned so that the cross section DM of the core middle leg portion encompasses the core end surfaces 15a and 15b of the current detection core 15.

In this manner, it is possible to pass a majority of the magnetic flux flowing through the magnetic core unit 2 of the sensor device 1 based on the magnetic flux (hereinafter, sometimes referred to as external magnetic flux) generated by the detection target current and flowing between the core end surfaces 15a and 15b of the current detection core 15 through the core middle leg portion of the magnetic core 2, and to pass the leaked portion thereof through the core outer leg portions of the magnetic core unit 2.

At this time, by making the area of the cross section DM of the core middle leg portion of the magnetic core unit 2 larger than the respective areas of the core end surfaces 15a and 15b of the current detection core 15, the magnetic resistance of the core middle leg portion becomes sufficiently small compared to the magnetic resistance of the air gap. As a result, even if some deviation occurs between the center of the cross section DM of the core middle leg portion and the center of the core end surfaces 15a and 15b, it is possible to suppress the magnetic flux leaking into the two core outer leg portions from being unbalanced.

In addition, as described in each of the embodiments described above, by outputting the detection signal capable of detecting the voltage balance between the coil portion L1 and the coil portion L2, it is possible to detect the amount and direction of the external magnetic flux generated by the detection target current with high accuracy, and accordingly to detect the magnitude and direction of the detection target current with high accuracy.

As the current sensor device 10 according to the fifth embodiment, it is preferable to provide a type in which the core end surfaces 15a and 15b of the current detection core 15 and the magnetic core unit 2 of the sensor device 1 are joined, and a type in which a clearance is provided between the core end surfaces 15a and 15b of the current detection core 15 and the magnetic core unit 2 of the sensor device 1.

Since the amount of external magnetic flux changes depending on the magnitude of the detection target current, by absorbing a change in the amount of external magnetic flux by the magnetic gap between the core end surfaces 15a and 15b of the current detection core 15 and the magnetic core unit 2 of the sensor device 1, even the sensor devices 1 having the same configurations can appropriately detect the detection target current. Specifically, in a case where the detection target current is large, the type in which a clearance is provided between the core end surfaces 15a and 15b of the current detection core 15 and the magnetic core unit 2 of the sensor device 1 is used, while in a case where the detection target current is small, the type in which the core end surfaces 15a and 15b of the current detection core 15 and the magnetic core unit 2 of the sensor device 1 are joined.

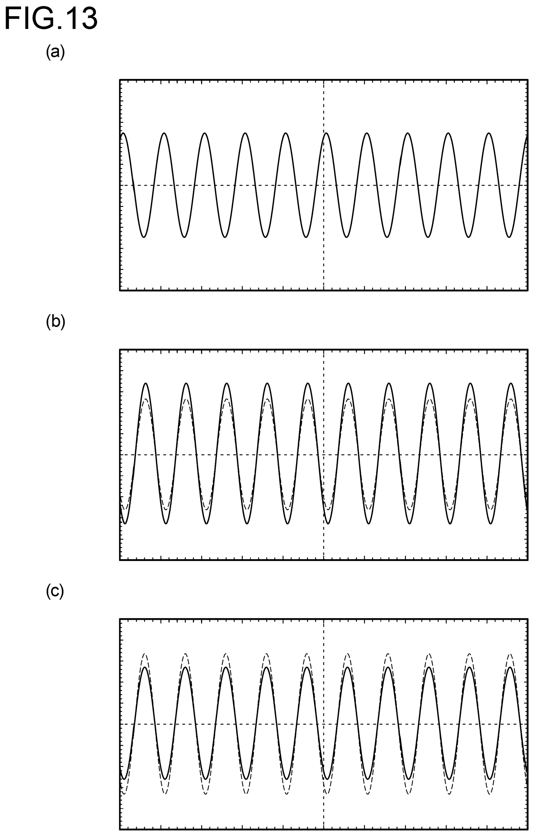

FIGS. 13A, 13B, and 13C are graphs each indicative of an example of voltage signals (detection signals) output from the signal output terminals V1 and V2 in the current sensor device 10 according to the fifth embodiment. All of the graphs indicate detection signals output with an AC signal having a frequency of 1,000 kHz (kilohertz) being applied to the coil portions L1 and L2 by the AC signal circuit 3.

FIG. 13A indicates a state in which the detection target current is not passed through the current line 12, FIG. 13B indicates a state in which the detection target current is passed through the current line 12, and FIG. 13C indicates a state in which the detection target current having the same magnitude as FIG. 13B is passed through the current line 12 in the opposite direction to FIG. 13B.

Furthermore, the solid line indicates the voltage signal output from the signal output terminal V1, and the dashed line indicates the voltage signal output from the signal output terminal V2.

FIG. 13A indicates that, in a case where no external magnetic field is generated by the detection target current, there is no difference between the voltage signals output from the signal output terminals V1 and V2.

FIGS. 13B and 13C indicate that, in a case where the detection target current is flowing through the current line 12, there is a difference between the voltage signals output from the signal output terminals V1 and V2, and, it is understood that, the magnitude of the difference makes it possible to detect the intensity of the external magnetic field generated by the detection target current and the magnitude of the detection target current.

Furthermore, in FIGS. 13B and 13C, the largeness and smallness of the voltage signals output from the signal output terminals V1 and V2 are reversed. Thus, it is understood that, by comparing the largeness and smallness of the voltage signals output from the signal output terminals V1 and V2, it is possible to detect the direction of the external magnetic field generated by the detection target current and the direction of the detection target current.

### [Sixth Embodiment]

Although the current sensor device 10 according to the fifth embodiment described above includes the current detection core 15, while the current sensor device 10 may not include the current detection core 15 and be configured so that the sensor device 1 is placed at a position in the vicinity of the current line 12. Also in this case, a flow of the detection target current enables the sensor device 1 to detect the external magnetic field generated around the current line 12, and it is possible to detect the magnitude and direction of the detection target current similarly to the fifth embodiment. In this case, in a case where the intensity of the external magnetic field is small, the magnetic core unit 2 of the sensor device 1 may have a shape not provided with the core middle leg portion.

The current sensor device 10 according to the sixth embodiment only needs to include the sensor device 1 according to the first, second, third, or fourth embodiment described above, and the sensor device 1 is installed in the vicinity of or in contact with the current line 12.

The shape of the current line 12 is a bar shape in the example of FIG. 11, but the shape is not limited to such a shape. The current line 12 may be any conductor having electrical conductivity in a plate shape or a bar shape called bus bar or the like.

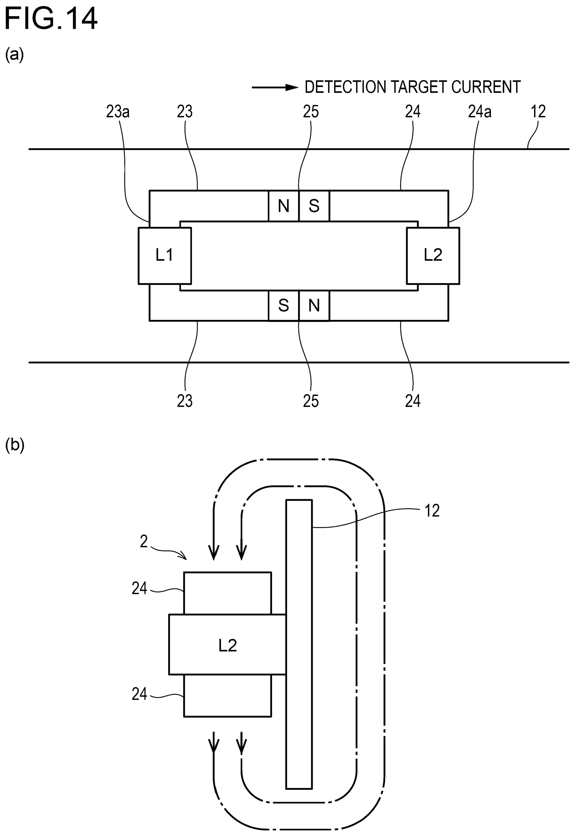

FIGS. 14 are schematic diagrams each indicative of an example of the placement of the current sensor device 10 according to the sixth embodiment with respect to the current line 12.

As indicated in FIGS. 14, the current sensor device 10 is placed so that the two coil portions L1 and L2 of the sensor device 1 are in the vicinity of or in contact with the conductor (current line 12) through which the detection target current flows. In the example of FIGS. 14, the sensor device 1 according to the fourth embodiment is exemplified, the coil portions L1 and L2 are in the vicinity of the conductor, and the sensor device 1 is placed so that the arrangement of the coil portions L1 and L2 generally matches the flowing direction of the detection target current.

With this placement, as indicated in FIG. 14B, the external magnetic field generated by the detection target current acts in the same manner on both of the outer leg portions 23a and 24a of the magnetic core 2, especially on the portions provided with the coil portions L1 and L2 thereof, and the voltage difference between the coil portion L1 and the coil portion L2 does not occur in a case where no external magnetic field is generated by the detection target current. Therefore, it is possible to detect, by the voltage difference, the magnitude and direction of the detection target current with high accuracy.

### [Seventh Embodiment]

In the first to fourth embodiments described above, the intensity and direction of the external magnetic field can be detected by outputting the difference between voltages generated in the coil portions L1 and L2 by the action of the external magnetic field. However, in the fourth embodiment described above, since the bias magnet portion 25 is interposed between the U-type core 23 and the U-type core 24 in the magnetic core unit 2, leakage magnetic flux corresponding to the voltage difference between the coil portions L1 and L2 may be generated in some cases from the gap between the cores. In this case, when this leakage magnetic flux couples with the external magnetic field, undesired noise may be superimposed on the detection target current that is generating the external magnetic field.

Therefore, the sensor device 1 according to a seventh embodiment is configured to circulate the signal magnetic flux generated from the coil portion L1 and the signal magnetic flux generated from the coil portion L2 in different closed magnetic paths, to thereby prevent generation of leakage magnetic flux corresponding to the voltage difference between the coil portions L1 and L2.

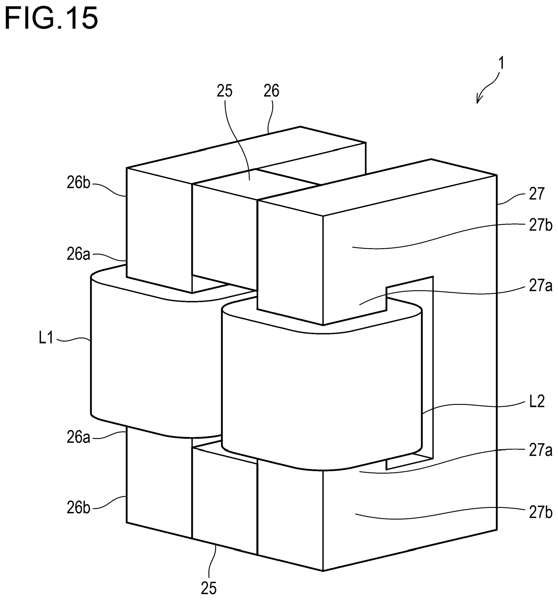

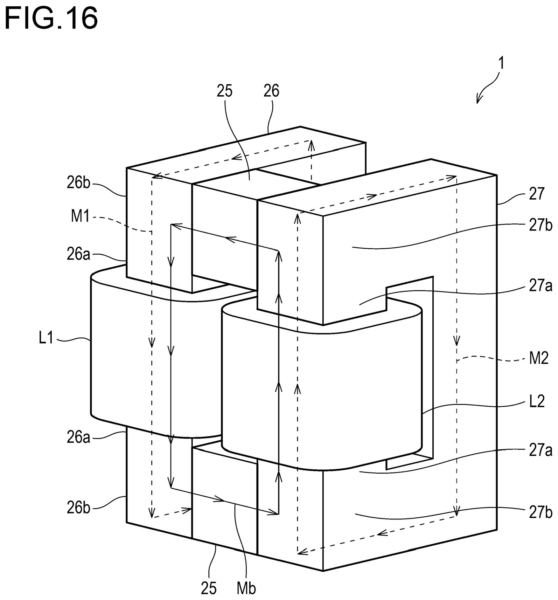

Hereinafter, the sensor device 1 according to the seventh embodiment will be described with reference to FIGS. 15 and 16.

FIG. 15 is a schematic diagram indicative of the appearance of the sensor device 1 according to the seventh embodiment, and FIG. 16 is a schematic diagram indicative of flows of signal magnetic flux and bias magnetic flux in the sensor device 1 according to the seventh embodiment. In the following description, description will be made mainly focusing on the configuration different from that in the first embodiment, and the description will not be repeated for the configuration same as that in the first embodiment.

The sensor device 1 according to the seventh embodiment includes a magnetic core unit, the coil portions L1 and L2, the bias magnet portions 25, the AC signal circuit 3, the signal output circuit 7, the signal output terminal Vout, the ground terminal GND, and the like, and the configuration of the magnetic core unit is different from each of the embodiments described above. The bias magnet portions 25 are as described in the fourth embodiment, and other configurations are also as described in any of the embodiments.

The sensor device 1 according to the seventh embodiment has structure in which a ring core 26 provided with the coil portion L1 and a ring core 27 provided with the coil portion L2 are connected to each other via two bias magnet portions 25. The ring core 26 corresponds to a second magnetic core unit and the ring core 27 corresponds to a third magnetic core unit.

Specifically, the windings of the coil portion L1 are wound around one outer leg portion 26a of the ring core 26, and the windings of the coil portion L2 are wound around one outer leg portion 27a of the ring core 27. In addition, one surface of the ring core 26 provided with an opening and one surface of the ring core 27 provided with an opening are opposed to each other. Each of the two bias magnet portions 25 is interposed between outer leg end portions 26b and 27b, the outer leg end portions 26b and the outer leg end portions 27b respectively existing at respective ends of the outer leg portions 26a and the outer leg portions 27a provided with the coil portions L1 and L2, respectively, in the opposed surfaces.

With such a configuration of the magnetic core unit, bias magnetic flux and signal magnetic flux are generated as indicated in FIG. 16.

Specifically, signal magnetic flux M1 generated from the coil portion L1 along with the AC signal applied by the AC signal circuit 3 has polarity to circulate in the closed magnetic path (corresponding to a second closed magnetic path) in the ring core 26 provided with the coil portion L1, and signal magnetic flux M2 generated from the coil portion L2 along with the AC signal has polarity to circulate in the closed magnetic path (corresponding to a third closed magnetic path) in the ring core 27 provided with the coil portion L2.

On the other hand, as indicated in FIG. 16, bias magnetic flux Mb generated by the bias magnet portions 25 has polarity to circulate in the closed magnetic path (corresponding to the first closed magnetic path) formed by the two bias magnet portions 25, a part of the ring core 26 (outer leg portions 26a and outer leg end portions 26b) and a part of the ring core 27 (outer leg portions 27a and outer leg end portions 27b).

Therefore, in the seventh embodiment, the two bias magnet portions 25, a part of the ring core 26 (outer leg portions 26a and outer leg end portions 26b) and a part of the ring core 27 (outer leg portions 27a and outer leg end portions 27b) correspond to the first magnetic core unit forming the first closed magnetic path.

As indicated in FIG. 16, in each of the outer leg portions 26a and the outer leg portions 27a provided with the coil portions L1 and L2, respectively, the bias magnetic flux Mb flows in the same direction (has the polarity in the same direction) with each of the signal magnetic fluxes M1 and M2.

In the seventh embodiment, the magnetic flux generation unit can be represented as including two or more bias magnet portions 25 provided locally in the first magnetic core unit so as to generate bias magnetic fluxes having polarity to circulate in the same direction through the first closed magnetic path described above.

With such a configuration of the magnetic core unit, the bias magnetic flux Mb is added to the signal magnetic fluxes M1 and M2 to enable generation of a magnetizing force within the specific range in the permeability decay region in the core properties of the ring cores 26 and 27, at least in the outer leg portions 26a and 27a provided with the coil portions L1 and L2, respectively.

Besides, since the signal magnetic fluxes M1 and M2 can be circulated in separate closed magnetic paths (in the ring core 26 and in the ring core 27), it is possible to prevent generation of leakage magnetic flux corresponding to the voltage difference between the coil portions L1 and L2 caused by the action of the external magnetic field.

As a result, even in a case where the sensor device 1 according to the seventh embodiment is used as a current sensor as described below, it is possible to prevent undesired noise from being superimposed on the detection target current that is generating the external magnetic field.

However, the core shape of the ring cores 26 and 27 is not limited to the ring core as long as being capable of forming a closed magnetic path for the signal magnetic flux, and may be an O-type core, UU-type core, UI-type core, or the like. Furthermore, the ring cores 26 and 27 only need to be a general magnetic core such as a ferrite core or a dust core, and a material and a forming method thereof are not limited.

Furthermore, the placement of the bias magnet portions 25 is also not limited to the example of FIG. 15. For example, the bias magnet portions 25 may be longer than those in the example of FIG. 15, and, instead of being interposed between the ring cores 26 and 27, may be provided so as to be joined to the end surfaces of the ring cores 26 and 27 on further outer sides than the surfaces of the ring cores 26 and 27 provided with the openings and be bridged between the ring cores 26 and 27. That is, the two bias magnet portions 25 may be placed so that the closed magnetic path through which the bias magnetic flux circulates is formed by the two bias magnet portions 25, a part of the ring core 26 (including the outer leg portions 26a) and a part of the ring core 27 (including the outer leg portions 27a).

Moreover, although there is a possibility that the closed magnetic path through which the bias magnetic flux circulates diverges, the bias magnet portions 25 may be placed at positions deviated from the outer leg end portions 26b existing at respective ends of the outer leg portions 26a and 27a.

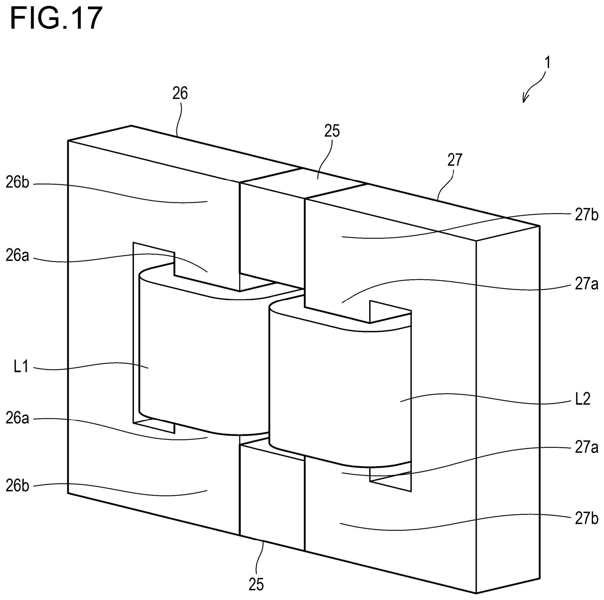

In the example of FIG. 15, the ring cores 26 and 27 are provided so that the surfaces having openings are opposed to each other, but may be placed as indicated in FIG. 17.

FIG. 17 is a schematic diagram indicative of the appearance of the sensor device 1 according to a modification of the seventh embodiment.

In the modification indicated in FIG. 17, the ring cores 26 and 27 are placed so that the surfaces having openings are arranged in parallel to each other and the outer (side opposite to the inner side where the opening portions are provided) end surfaces of the outer leg portions 26a and 27a provided with the coil portions L1 and L2, respectively, are opposed to each other.

Furthermore, the ring cores 26 and 27 are mutually coupled via the two bias magnet portions 25 provided between the outer (side opposite to the inner side where the opening portions are provided) end surfaces of the outer leg end portions 26b and 27b existing at respective ends of the outer leg portions 26a and 27a.

Even with such a configuration, similarly to the example of FIG. 16, the signal magnetic flux M1 generated from the coil portion L1 circulates in the closed magnetic path in the ring core 26 provided with the coil portion L1, the signal magnetic flux M2 generated from the coil portion L2 circulates in the closed magnetic path in the ring core 27 provided with the coil portion L2, and the bias magnetic flux Mb generated by the bias magnet portions 25 circulates in the closed magnetic path (corresponding to the first closed magnetic path) formed by the two bias magnet portions 25, a part of the ring core 26 (outer leg portions 26a and outer leg end portions 26b) and a part of the ring core 27 (outer leg portions 27a and outer leg end portions 27b).

Therefore, even in this modification, it is possible to prevent generation of leakage magnetic flux corresponding to the voltage difference between the coil portions L1 and L2 caused by the action of the external magnetic field.

### [Eighth Embodiment]

Also, by placing the sensor device 1 according to the seventh embodiment described above at a position in the vicinity of or in contact with the current line 12 in the same manner as the sixth embodiment described above, it is possible to realize a current sensor device that detects the magnitude and direction of the detection target current flowing through the current line 12.

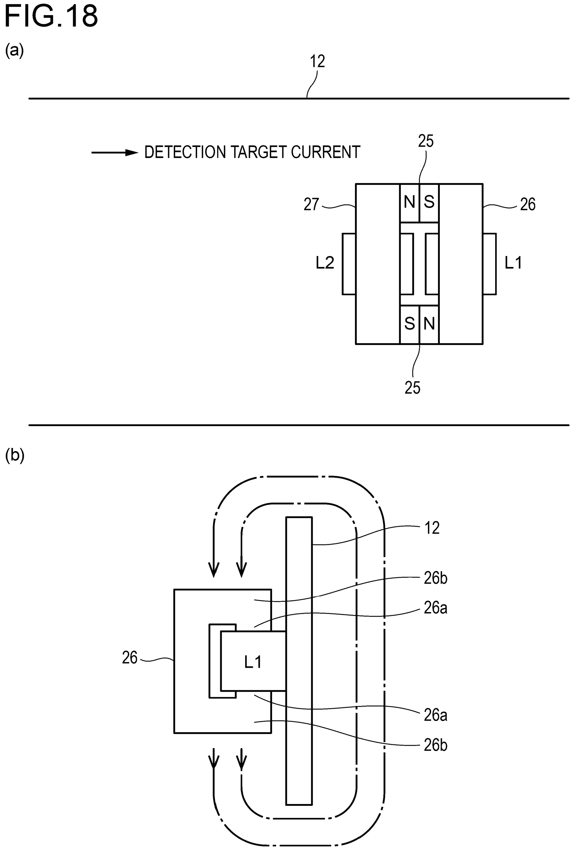

FIGS. 18 are schematic diagrams each indicative of an example of the placement of the current sensor device 10 according to an eighth embodiment with respect to the current line 12.

As indicated in FIGS. 18, the current sensor device 10 is placed so that the two coil portions L1 and L2 of the sensor device 1 are in the vicinity of or in contact with the conductor (current line 12) through which the detection target current flows. Also in the eighth embodiment, similarly to the sixth embodiment, the sensor device 1 is placed so that the arrangement of the coil portions L1 and L2 roughly matches the flowing direction of the detection target current.

Furthermore, in the placement in the eighth embodiment, the plane (virtual plane) of the closed magnetic path in which the bias magnetic flux Mb circulates is parallel to the current line 12, and the plane (virtual plane) of the closed magnetic path in which the signal magnetic fluxes M1 and M2 circulate is orthogonal to the current line 12.

With this placement, also in the eighth embodiment, the external magnetic field generated by the detection target current acts in the same manner on both of the outer leg portions 26a and 27a provided with the coil portions L1 and L2, respectively, and it is possible to detect the magnitude and direction of the detection target current with high accuracy by the voltage difference between the coil portion L1 and the coil portion L2 caused by the action of the external magnetic field.

Also in the case of using the sensor device 1 (see FIG. 17) according to the modification of the seventh embodiment, similarly to the above, the sensor device 1 is placed so that the two coil portions L1 and L2 are in the vicinity of or in contact with the conductor (current line 12) through which the detection target current flows and the arrangement of the coil portions L1 and L2 roughly matches the flowing direction of the detection target current.

In this case, since both of the plane (virtual plane) of the closed magnetic path through which the bias magnetic flux Mb circulates and the plane (virtual plane) of the closed magnetic path through which the signal magnetic fluxes M1 and M2 circulate are parallel to the current line 12, the external magnetic field (main magnetic flux) generated by the detection target current acts in the same manner entirely on the ring cores 26 and 27. As a result, the amount of change in permeability of the entire core of the ring cores 26 and 27 is increased, which improves the detection sensitivity.

Also in this case, since it is possible to prevent generation of leakage magnetic flux corresponding to the voltage difference between coil portions L1 and L2 caused by the action of the external magnetic field, it is possible to prevent undesired noise from being superimposed on the detection target current that is generating the external magnetic field.

### [Modification]

The details of each of the embodiments described above can be modified as appropriate. That is, the sensor device 1 and the current sensor device 10 according to each embodiment are not limited to the circuit configuration examples indicated in the drawings.

There is a possibility that the relationship between the position of the magnetic core unit 2 of the sensor device 1 and the direction of the external magnetic field and the like may cause the magnetic flux flowing through the core outer leg portions based on the external magnetic field in the magnetic core unit 2 to be unbalanced on both sides. For example, this applies to the case where, in the fourth embodiment described above, for example, the magnetic core unit 2 is not positioned in such placement that the cross section DM of the core middle leg portions encompasses the respective core end surfaces 15a and 15b of the current detection core 15.

In such a case, a correction circuit element corresponding to the unbalanced state of the magnetic flux between the core outer leg portions is provided in the AC signal circuit 3 or after the signal output terminals V1 and V2 to correct the output signal (detection signal), to thereby achieve the same operational effects as those in each of the embodiments described above. The correction circuit element in this case is, for example, a circuit that biases either or both of the coil portions L1 or L2 to offset the magnetic flux imbalance.

The inventors conducted an evaluation test of the current sensor device 10 described above, and the contents and results of the evaluation test are described below as Examples.

### EXAMPLES

As the current sensor devices 10 as an evaluation target, the sensor device 1 according to the fourth embodiment, in which the AC signal circuit 3 and the signal output circuit 7 are implemented as a first example indicated in FIG. 7 was used.

In this evaluation test, in the AC signal circuit 3, the input power (DC power supply) was set to Vin 3.3 (V) and Iin 4.8 (mA), and the oscillation frequency was set to 1250 kHz. The current sensor device 10 housed in a case was fixed to a bus bar, and the voltage of the output signal output from the signal output terminal Vout of the current sensor device 10 was measured while changing the magnitude of the detection target current flowing through the bus bar.

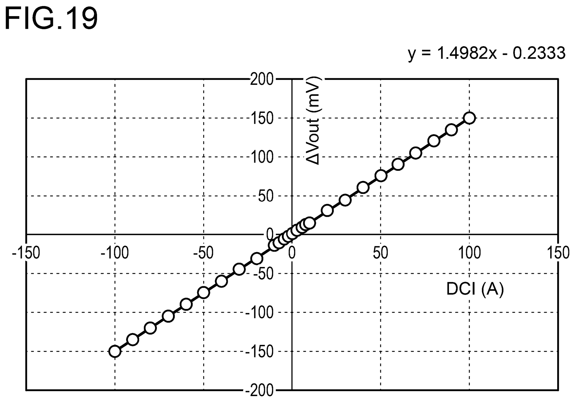

FIG. 19 is a graph indicative of results of the evaluation test of the current sensor device 10 in this Example. The horizontal axis shows the current value (DCI (A)) of the detection target current passed through the bus bar, and the vertical axis shows the voltage change amount (ΔVout (mV)) in the output signal from the current sensor device 10.

The current value of the detection target current was changed to 0 (A), ±2 (A), ±4 (A), ±6 (A), ±8 (A), ±10 (A), ±20 (A), ±30 (A), ±40 (A), ±50 (A), ±60 (A), ±70 (A), ±80 (A), ±90 (A), and ±100 (A). The voltage values of the output signals when the detection target current of the respective current values was passed were measured, and the respective differences (ΔVout (mV)) from the voltage values of the output signals when no detection target current flows, that is, the current value of the detection target current was 0 (A), were calculated.

FIG. 19 is a graph obtained by plotting the combinations of the voltage change amounts of the output signals thus calculated and the current values of the detection target current.

Based on this graph, an approximate straight line (theoretical formula) y = 1.4982x - 0.2333 was obtained using the least squares method.

The theoretical value of the voltage change amount was calculated for each current value of the detection target current using this theoretical formula, and the linearity error was calculated by dividing the difference between each theoretical value of the calculated voltage change amount and each measured value by the full-scale voltage (F.S.).

As a result, it was substantiated that, according to the current sensor device 10 of the evaluation test target, the linearity error in a case where the current value of the detection target current was made variable in the range of +100 (A) could be suppressed to equal to or less than 0.28%. That is, it was substantiated that high detection accuracy could be realized according to the current sensor device 10 of the evaluation test target.

In addition, it was substantiated that this current sensor device 10 could also suppress power consumption (Vin 3.3 (V), Iin 4.8 (mA)) by, for example, not using a Hall element, using magnets (bias magnet portions 25) for generation of the bias magnetic flux, and employing a simple self-oscillation circuit.

Some or all of the above embodiments and modification may also be specified as follows. However, the above embodiments and modifications are not limited to the following descriptions.

<1> A sensor device comprising:
   a first magnetic core unit capable of forming a first closed magnetic path including two outer leg portions;
   two coil portions that are constituted by windings being wound around the two outer leg portions, respectively, and generate respective signal magnetic fluxes according to AC signals applied;
   a magnetic flux generation unit that generates a bias magnetic flux to circulate in the first closed magnetic path;
   an AC signal circuit that applies an AC signal to the two coil portions so as to generate the signal magnetic flux in the same direction as the bias magnetic flux at the outer leg portions; and
   signal output terminals that output a detection signal capable of detecting voltage balance between the two coil portions, the voltage balance changing depending on an external magnetic field acting on the first magnetic core unit.
<2> The sensor device according to <1> above, wherein
   the magnetic flux generation unit generates the bias magnetic flux having such a magnetizing force that falls in a permeability range of equal to or more than 40% and equal to or less than 60%, the permeability range corresponding to a specific range within a region in which the permeability decays linearly with an increase in the magnetizing force in core properties of the magnetic core unit provided with the two coil portions.
<3> The sensor device according to <2> above, wherein
   the signal magnetic fluxes generated from the two coil portions have polarity to circulate in the same direction in the first closed magnetic path,
   the AC signal circuit includes the magnetic flux generation unit, and
   the AC signal circuit applies, to the two coil portions, the AC signal on which a DC bias current corresponding to the bias magnetic flux is superimposed.
<4> The sensor device according to <2> above, wherein
   the signal magnetic fluxes generated from the two coil portions have polarity to circulate in the same direction in the first closed magnetic path,
   the magnetic flux generation unit includes,
   two bias coil portions constituted by windings being wound around the two outer leg portions, respectively, and
   a DC signal circuit that applies a DC signal to the two bias coil portions so as to generate the bias magnetic fluxes having polarity to circulate in the same direction in the first closed magnetic path.
<5> The sensor device according to <2> above, wherein
   the signal magnetic fluxes generated from the two coil portions have polarity to circulate in the same direction in the first closed magnetic path, and
   the magnetic flux generation unit includes a bias magnet portion locally provided in the first magnetic core unit so as to generate the bias magnetic fluxes having polarity to circulate in the same direction in the first closed magnetic path.
<6> The sensor device according to <1> or <2> above, further comprising:
   a second magnetic core unit capable of forming a second closed magnetic path including one of the two outer leg portions and another outer leg portion; and
   a third magnetic core unit capable of forming a third closed magnetic path including the other one of the two outer leg portions and another outer leg portion, wherein
   the magnetic flux generation unit includes two or more bias magnet portions locally provided in the first magnetic core unit so as to generate the bias magnetic fluxes having polarity to circulate in the same direction in the first closed magnetic path,
   the signal magnetic flux generated from one of the two coil portions has polarity to circulate in the second closed magnetic path,
   the signal magnetic flux generated from the other one of the two coil portions has polarity to circulate in the third closed magnetic path,
   the second magnetic core unit and the third magnetic core unit are coupled to each other via the two or more bias magnet portions, and
   the first closed magnetic path is formed by the two or more bias magnet portions, a part of the second magnetic core unit, and a part of the third magnetic core unit.
<7> The sensor device according to any one of <1> to <6> above, wherein
   the two coil portions are installed in the vicinity of or in contact with a conductor through which detection target current flows, and
   the detection signal enables measurement of a current value of the detection target current.
<8> The sensor device according to any one of <1> to <7> above, wherein
   the two coil portions are connected in series in the AC signal circuit, and
   the signal output terminals are capable of outputting an intermediate signal level of the two coil portions as the detection signal.
<9> The sensor device according to <8> above, wherein
   the AC signal circuit includes a self-oscillation circuit having a resonant capacitor connected in parallel to the two coil portions, and an oscillation signal output from the self-oscillation circuit is applied to respective ends of the two coil portions.
<10> The sensor device according to any one of <1> to <5> and <8> and <9> above, further comprising
   a magnetic core for current detection that has an air gap and in which the air gap is interposed in a magnetic path formed by a flow of a detection target current, wherein
   the signal magnetic fluxes generated from the two coil portions have polarity to circulate in the same direction in the first closed magnetic path,
   the magnetic core unit further includes a middle leg portion, and is placed in the air gap in a direction in which the two outer leg portions and the middle leg portion extend in a direction orthogonal to core end surfaces of the magnetic core for current detection opposed to each other via the air gap,
   an area of a cross section orthogonal to an extending direction in the middle leg portion of the magnetic core unit is the same as or larger than respective areas of the core end surfaces of the magnetic core for current detection, and
   the magnetic core unit is positioned so that the cross section of the middle leg portion encompasses the core end surfaces of the magnetic core for current detection when viewed from a direction orthogonal to the core end surfaces.
<11> The sensor device according to <10> above, wherein
   the core end surfaces of the magnetic core for current detection are joined to the magnetic core unit.
<12> The sensor device according to <10> above, wherein
   a clearance is provided between the respective core end surfaces of the magnetic core for current detection and the magnetic core unit.

This application claims priority based on International Application No. PCT/JP2023/42221 filed on November 24, 2023, disclosure of which is entirely incorporated herein.

### REFERENCE SIGNS LIST

- 1: sensor device
- 2: magnetic core unit
- 3: AC signal circuit
- 5: DC signal circuit
- 7: signal output circuit
- 10: current sensor device
- 12: current line
- 15: current detection core
- 15a, 15b: core end surface
- 21, 22: E-type core
- 23, 24: U-type core
- 25: bias magnet portion
- 26, 27: ring core
- L1, L2: coil portion
- V1, V2,: Vout signal output terminal

## Claims

1. A sensor device comprising:
a first magnetic core unit capable of forming a first closed magnetic path including two outer leg portions;
two coil portions that are constituted by windings being wound around the two outer leg portions, respectively, and generate respective signal magnetic fluxes according to AC signals applied;
a magnetic flux generation unit that generates a bias magnetic flux to circulate in the first closed magnetic path;
an AC signal circuit that applies an AC signal to the two coil portions so as to generate the signal magnetic flux in the same direction as the bias magnetic flux at the outer leg portions; and
signal output terminals that output a detection signal capable of detecting voltage balance between the two coil portions, the voltage balance changing depending on an external magnetic field acting on the first magnetic core unit.

2. The sensor device according to claim 1, wherein
the magnetic flux generation unit generates the bias magnetic flux having such a magnetizing force that falls in a permeability range of equal to or more than 40% and equal to or less than 60%, the permeability range corresponding to a specific range within a region in which the permeability decays linearly with an increase in the magnetizing force in core properties of the magnetic core unit provided with the two coil portions.

3. The sensor device according to claim 2, wherein
the signal magnetic fluxes generated from the two coil portions have polarity to circulate in the same direction in the first closed magnetic path,
the AC signal circuit includes the magnetic flux generation unit, and
the AC signal circuit applies, to the two coil portions, the AC signal on which a DC bias current corresponding to the bias magnetic flux is superimposed.

4. The sensor device according to claim 2, wherein
the signal magnetic fluxes generated from the two coil portions have polarity to circulate in the same direction in the first closed magnetic path,
the magnetic flux generation unit includes,
two bias coil portions constituted by windings being wound around the two outer leg portions, respectively, and
a DC signal circuit that applies a DC signal to the two bias coil portions so as to generate the bias magnetic fluxes having polarity to circulate in the same direction in the first closed magnetic path.

5. The sensor device according to claim 2, wherein
the signal magnetic fluxes generated from the two coil portions have polarity to circulate in the same direction in the first closed magnetic path, and
the magnetic flux generation unit includes a bias magnet portion locally provided in the first magnetic core unit so as to generate the bias magnetic fluxes having polarity to circulate in the same direction in the first closed magnetic path.

6. The sensor device according to claim 1 or 2, further comprising:
a second magnetic core unit capable of forming a second closed magnetic path including one of the two outer leg portions and another outer leg portion; and
a third magnetic core unit capable of forming a third closed magnetic path including the other one of the two outer leg portions and another outer leg portion, wherein
the magnetic flux generation unit includes two or more bias magnet portions locally provided in the first magnetic core unit so as to generate the bias magnetic fluxes having polarity to circulate in the same direction in the first closed magnetic path,
the signal magnetic flux generated from one of the two coil portions has polarity to circulate in the second closed magnetic path,
the signal magnetic flux generated from the other one of the two coil portions has polarity to circulate in the third closed magnetic path,
the second magnetic core unit and the third magnetic core unit are coupled to each other via the two or more bias magnet portions, and
the first closed magnetic path is formed by the two or more bias magnet portions, a part of the second magnetic core unit, and a part of the third magnetic core unit.

7. The sensor device according to any one of claims 1 to 6, wherein
the two coil portions are installed in the vicinity of or in contact with a conductor through which detection target current flows, and
the detection signal enables measurement of a current value of the detection target current.

8. The sensor device according to any one of claims 1 to 7, wherein
the two coil portions are connected in series in the AC signal circuit, and
the signal output terminals are capable of outputting an intermediate signal level of the two coil portions as the detection signal.

9. The sensor device according to claim 8, wherein
the AC signal circuit includes a self-oscillation circuit having a resonant capacitor connected in parallel to the two coil portions, and an oscillation signal output from the self-oscillation circuit is applied to respective ends of the two coil portions.

10. The sensor device according to any one of claims 1 to 5, 8 and 9, further comprising
a magnetic core for current detection that has an air gap and in which the air gap is interposed in a magnetic path formed by a flow of a detection target current, wherein
the signal magnetic fluxes generated from the two coil portions have polarity to circulate in the same direction in the first closed magnetic path,
the first magnetic core unit further includes a middle leg portion, and is placed in the air gap in a direction in which the two outer leg portions and the middle leg portion extend in a direction orthogonal to core end surfaces of the magnetic core for current detection opposed to each other via the air gap,
an area of a cross section orthogonal to an extending direction in the middle leg portion of the first magnetic core unit is the same as or larger than respective areas of the core end surfaces of the magnetic core for current detection, and
the first magnetic core unit is positioned so that the cross section of the middle leg portion encompasses the core end surfaces of the magnetic core for current detection when viewed from a direction orthogonal to the core end surfaces.

11. The sensor device according to claim 10, wherein
the core end surfaces of the magnetic core for current detection are joined to the first magnetic core unit.

12. The sensor device according to claim 10, wherein
a clearance is provided between the respective core end surfaces of the magnetic core for current detection and the first magnetic core unit.
